(19) Europäisches Patentamt
European Patent Office
Office européen des brevets

(11) EP 3 142 163 A1

(12) **EUROPEAN PATENT APPLICATION**

(43) Date of publication:
**15.03.2017 Bulletin 2017/11**

(51) Int Cl.:
***H01L 51/52** (2006.01)* ***F21S 8/10** (2006.01)*

(21) Application number: **16180897.7**

(22) Date of filing: **22.07.2016**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **08.09.2015 JP 2015176240**

(71) Applicant: **Konica Minolta, Inc.**
**Tokyo 100-7015 (JP)**

(72) Inventors:
- **Kato, Kazuki**
  **Tokyo, 100-7015 (JP)**
- **Matsumura, Toshiyuki**
  **Tokyo, 100-7015 (JP)**

(74) Representative: **Henkel, Breuer & Partner**
**Patentanwälte**
**Maximiliansplatz 21**
**80333 München (DE)**

(54) **ORGANIC ELECTROLUMINESCENT ELEMENT AND VEHICLE LAMP FITTING**

(57) Provided is an organic electroluminescent element containing a flexible substrate having thereon a first electrode layer, an organic layer unit containing a light-emitting layer formed on the first electrode layer, and a second electrode layer formed on the organic layer unit, wherein the organic electroluminescent element emits light to an outside of the organic electroluminescent element with a light distribution property of the emitted light satisfying the following relationships of: $0.85 \leq L2/L1 \leq 1.20$; and $L3/L1 \leq 0.45$, provided that L1 is a front luminance, L2 is a luminance of view angle 20 degrees, and L3 is a luminance of view angle 60 degrees.

*FIG.1*

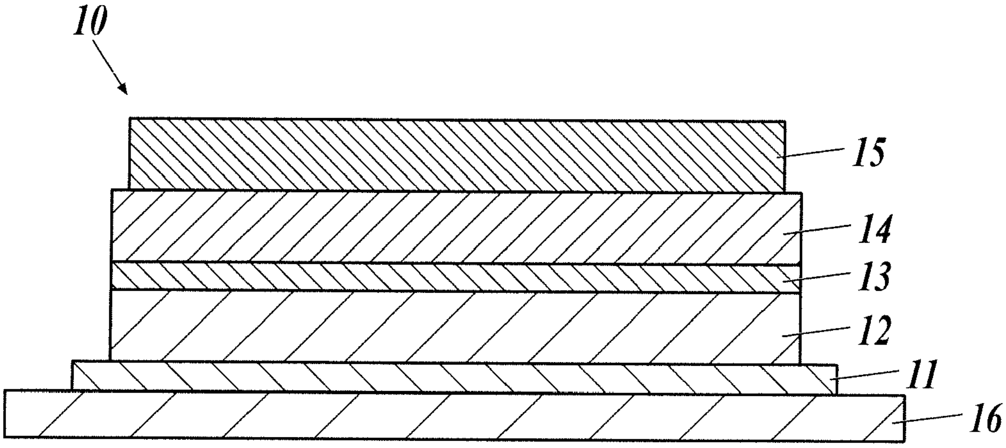


EP 3 142 163 A1

## Description

This application is based on Japanese Patent Application No. 2015-176240 filed on September 8, 2015 with Japan Patent Office, the entire content of which is hereby incorporated by reference.

## TECHNICAL FIELD

The present invention relates to an organic electroluminescent element and a vehicle lamp fitting. In particular, the present invention relates to an organic electroluminescent element achieving high visibility and uniform brightness of the emission light when it is viewed from the rear vehicle, and a vehicle lamp fitting using the same.

## BACKGROUND

In the past, it was proposed an organic electroluminescent element using a light-emitting material realizing high emission efficiency by utilizing all of the singlet exciton and the triplet exciton to convert to electroluminescence (hereafter, it is also called as "EL"). In an organic electroluminescent element, there have been developed materials attaining a practical level with respect to both emission efficiency and high lifetime. They have been used for a display or a lighting device.

In recent years, it was proposed a vehicle lamp fitting (for example, a tail lamp) with a high design level by utilizing the properties of the organic electroluminescent element such as surface emission and flexibility (refer to Patent document No. 1: JP-A No. 2015-5552, for example).

When the organic electroluminescent element having a surface emitting source is loaded on a vehicle in a bent condition, it is required that the curved portion of the organic electroluminescent element also emits strongly for the purpose of ensuring visibility and uniform brightness to the following vehicle. Therefore, it is required a strong emission not only from the front direction but also from the view angle of about 20 degrees. On the other hand, it is not required a strong emission from the view angle of about 60 to 90 degrees from the viewpoint of the visibility and the uniform brightness to the following vehicle.

Conventionally known organic EL elements were made to emit light with the certain visibility from every direction. However, there were emitted light at view angle of about 60 to 90 degrees. Therefore, there was a large amount of useless emitted light.

## SUMMARY

The present invention was done based on the above-described problems and situations. An object of the present invention is to provide an organic electroluminescent element achieving high visibility and uniform brightness of the emission light when it is viewed from the rear vehicle, and a vehicle lamp fitting using the same.

The present inventors have investigated the reasons of the above-described situation to solve the above-described object of the present invention. As a result, it was found to provide an organic electroluminescent element achieving high visibility and uniform brightness of the emission light when it was viewed from the rear vehicle. This organic electroluminescent element contains a flexible substrate and an organic layer unit, wherein the organic electroluminescent element has a light distribution property of light emitted to an outside of the organic electroluminescent element, the light distribution property satisfying a specific relationship of a front luminance L1, a luminance of view angle 20 degrees L2, and a luminance of view angle 60 degrees L3.

That is, the object of the present invention is solved by the following embodiments.

1. An organic electroluminescent element comprising a flexible substrate having thereon a first electrode layer, an organic layer unit containing a light-emitting layer formed on the first electrode layer, and a second electrode layer formed on the organic layer unit,
wherein the organic electroluminescent element emits light to an outside of the organic electroluminescent element with a light distribution property of the emitted light satisfying the following relationships of:

$$0.85 \leq L2/L1 \leq 1.20;$$

and

$$L3/L1 \leq 0.45,$$

provided that L1 is a front luminance, L2 is a luminance of view angle 20 degrees, and L3 is a luminance of view angle 60 degrees.
2. The organic electroluminescent element described in the embodiment 1,
wherein the front luminance L1, the luminance of view angle 20 degrees L2, and the luminance of view angle 60 degrees L3 satisfy the following relationships of:

$$0.90 \leq L2/L1 \leq 1.10;$$

and

$$L3/L1 \leq 0.45.$$

3. The organic electroluminescent element described in the embodiments 1 or 2,
having a front chromaticity satisfying the following relationships in a CIE-xy chromaticity diagram when the front luminance L1 is 1,000 cd/m$^2$:

$$0.29 \leq y \leq 0.335;$$

and

$$y + x \geq 0.98.$$

4. The organic electroluminescent element described in the embodiments 1 or 2,
having a front chromaticity satisfying the following relationships in a CIE-xy chromaticity diagram when the front luminance L1 is 1,000 cd/m$^2$:

$$y \geq 0.39;$$

$$y \geq 0.79 - 0.67x;$$

and

$$y \geq x - 0.120.$$

5. The organic electroluminescent element described in any one of the embodiments 1 to 4,
wherein two or more organic layer units are laminated between the first electrode layer and the second electrode layer.
6. A vehicle lamp fitting provided with the organic electroluminescent element described in any one of the embodiments 1 to 5.

The embodiments of the present invention enable to provide an organic electroluminescent element achieving high visibility and uniform brightness of the emission light when it is viewed from the rear vehicle, and to provide a vehicle lamp fitting using the same organic electroluminescent element.
A formation mechanism or an action mechanism of the effects of the present invention is supposed to be as follows.
In order to enhance visibility and uniform brightness of the organic EL element when viewed from the rear

vehicle, it is required to increase the strength of the emitted light from the front luminance (the luminance of view angle 0 degrees) to the luminance of view angle about 20 degrees of the organic EL element. The present inventors made extensive investigation and found out that there is a trade-off relation between the front luminance (the luminance of view angle 0 degrees) and the luminance of view angle 20 degrees. That is, when the front luminance is increased, the luminance of view angle 20 degrees is decreased, and as a result, the visibility and the brightness uniformity of the organic EL element are decreased when viewed from the rear vehicle. This tendency becomes remarkable when the light-emitting region of the organic EL element is bent and viewed from the front direction. Therefore, the front luminance and the luminance of view angle about 20 degrees may be kept sufficiently high level by making a specific light distribution property in which the luminance ratio of the luminance of view angle 20 degrees to the front luminance is made to be from 0.85 to 1.20. Thus, it may be improved the visibility of the emitted light when viewed from the rear vehicle. Further, by making the luminance of view angles from 60 to 90 degrees to have a low light distribution property, the emitted light allotted to the view angles may be used for the view angles of 0 to 20 degrees. As a result, the luminance of view angles about 0 to 20 degrees will be increased, and the visibility of the emitted light viewed from the rear vehicle will be increased.

In addition, it can obtain an effect of improving the emission lifetime of the organic EL element by making the light distribution property as described above.

## BRIEF DESCRIPTION OF THE DRAWINGS

FIG. 1 represents a drawing illustrating a schematic constitution of an organic EL element of the present invention.

FIG. 2 represents a drawing illustrating a schematic constitution of a vehicle lamp fitting equipped with an organic EL element of the present invention.

## DESCRIPTION OF THE PREFERRED EMBODIMENTS

An organic electroluminescent element of the present invention contains a flexible substrate having thereon a first electrode layer, an organic layer unit containing a light-emitting layer formed on the first electrode layer, and a second electrode layer formed on the organic layer unit. The organic electroluminescent element is characterized in emitting light to an outside of the organic electroluminescent element with a light distribution property of the emitted light satisfying the following relationships of: $0.85 \leq L2/L1 \leq 1.20$; and $L3/L1 \leq 0.45$, provided that L1 is a front luminance, L2 is a luminance of view angle 20 degrees, and L3 is a luminance of view angle 60 degrees. This feature is a technical feature commonly owned by the above-described embodiments 1 to 6.

In the present invention, it is preferable that the front luminance L1, the luminance of view angle 20 degrees L2, and the luminance of view angle 60 degrees L3 are adjusted to satisfy the following relationships of: $0.90 \leq L2/L1 \leq 1.10$; and $L3/L1 \leq 0.45$.

Further, in the present invention, it is preferable that the organic electroluminescent element has a front chromaticity satisfying the following relationships in a CIE-xy chromaticity diagram when the front luminance L1 is 1,000 $cd/m^2$: $0.29 \leq y \leq 0.335$; and $y + x \geq 0.98$. By this, it is possible to obtain emission light of red color.

Further, in the present invention, it is preferable that the organic electroluminescent element has a front chromaticity satisfying the following relationships in a CIE-xy chromaticity diagram when the front luminance L1 is 1,000 $cd/m^2$ : $y \geq 0.39$; $y \geq 0.79 - 0.67x$; and $y \geq x - 0.120$. By this, it is possible to obtain emission light of amber color.

Further, in the present invention, it is preferable that two or more organic layer units are laminated between the first electrode layer and the second electrode layer. By this, it is possible to obtain a sufficient amount of light emission even when it is driven with a low electric current. As a result, a lifetime of the organic EL element may be prolonged.

A vehicle lamp fitting of the present invention is characterized in having the above-described organic EL element. It is possible to make a vehicle lamp fitting having a high visibility and uniform brightness when it is viewed from the rear vehicle.

The present invention and the constitution elements thereof, as well as configurations and embodiments, will be detailed in the following. In the present description, when two figures are used to indicate a range of value before and after "to", these figures themselves are included in the range as a lowest limit value and an upper limit value.

[General outline of Organic EL element]

As illustrated in FIG. 1, an organic EL element 10 is provided with: an anode (a first electrode layer) 11, a first light-emitting unit (an organic layer unit) 12, an intermediate connector layer 13, a second light-emitting unit (an organic layer unit) 14, and a cathode (a second electrode layer) 15. These layers each are formed on a flexible substrate 16. The detail of these constitution members will be described later.

In the organic EL element 10, the anode 11 is formed on the flexible substrate 16, and the first light-emitting unit 12 is formed on the anode 11. Further, the intermediate connector layer 13 is formed on the first light-emitting unit 12, and the second light-emitting unit 14 is formed on the intermediate connector layer 13, and moreover, the cathode 15 is formed on the second light-emitting unit 14.

The organic EL element 10 has a so-called bottom emission type constitution in which the anode 11 is composed of a transparent electrode, and the cathode 15 has a function of a reflecting electrode, whereby light is extracted from the side of the flexible substrate 16.

It has a so-called tandem type constitution having the first light-emitting unit 12 and the second light-emitting unit 14 each laminated through the intermediate connector layer 13.

As other usable constitutions of the organic EL element 10, it may be used a son-called top emission type constitution in which the anode 11 is composed of a reflecting electrode, and the cathode 15 has a function of a transparent electrode, whereby light is extracted from the side of the cathode 15, or it may be used a transparent type constitution in which the anode 11 is composed of a transparent electrode, and the cathode 15 has a function of a transparent electrode, whereby light is extracted from the side of the flexible substrate 16 and the side of the cathode 15.

The first light-emitting unit 12 and the second light-emitting unit 14 each have at least one light-emitting layer containing a light-emitting organic material.

The organic EL element 10 of the present invention emits light to an outside of the organic electroluminescent element with a light distribution property of the emitted light satisfying the following relationships of : $0.85 \leq L2/L1 \leq 1.20$; and $L3/L1 \leq 0.45$, provided that L1 is a front luminance, L2 is a luminance of view angle 20 degrees, and L3 is a luminance of view angle 60 degrees.

Here, "a front" indicates an orthogonal direction to the predetermined location of the light-emitting region of the organic EL element. When the organic EL element is in a bent condition, "a front" indicates a normal direction with respect to the predetermined location of the light-emitting region of the organic EL element. In addition, "a view angle 20 degrees" and "a view angle 60 degrees" each represent an angle formed between the front direction and the eye line to be 20 degrees and 60 degrees.

When the luminance L1 to L3 fulfill the above-described relationships, the visibility of the emission light and uniform brightness may be improved when it is viewed from the rear vehicle.

In the present invention, it is preferable that the luminance L1 to L3 fulfill the relationships of: $0.90 \leq L2/L1 \leq 1.10$; and $L3/L1 \leq 0.45$. By this, the visibility of the organic EL element and uniform brightness may be further improved when it is viewed from the rear vehicle.

The above-described luminance L1 to L3 may be measured with the following method. An organic EL element is placed on a rotating stage that rotates automatically. The distribution of light intensity and the spectrum are measured with Spectroradiometer CS-2000 (made by Konica Minolta Inc.). Thus, the luminance L1 to L3 may be determined. In this measurement, while the organic EL element emits light by passing a constant electric current (5 $mA/cm^2$) to it, multiple measurements are carried out in the range of $\pm$ 80 degrees, provided that an orthogonal direction to the light-emitting region of the organic EL element is set to be 0 degrees.

Examples of a method for adjusting the luminance L1 to L3 of the organic EL element to be in the above-described range are the following two methods.

One of the methods is as follows. The light distribution property of the organic EL element 10 is adjusted to become within the above-described range by adjusting: the distance between the emission point of the organic EL element 10 and the anode 11; and the distance between the emission point and the cathode 15. In the organic EL element 10, when the light produced in the light-emitting layer is taken out, it is known that the light directly taken out from the light-emitting layer through the anode and the light reflected from the cathode that is located the place opposite to the anode will cause interference. Consequently, it is possible to change the distance between the emission point in the light-emitting layer of the first light-emitting unit 12 and the second light-emitting unit 14 and the anode 11 or the cathode 15 by adjusting each layer thickness of the organic layers constituting the first light-emitting unit 12 and the second light-emitting unit 14. Thus, it is possible to adjust the light distribution property of the organic EL element.

When each layer thickness of the organic layers constituting the first light-emitting unit 12 and the second light-emitting unit 14 is adjusted, it is preferable that the total thickness of the electron transport layer is suitably adjusted to be in the range from a few nm to 200 nm.

When the thickness is particularly thick, electron mobility in the electron transport layer is preferably $10^{-5}$ $cm^2/Vs$ or more.

The thickness of each layer which enables to make the light distribution property of the organic EL element to be in the above-described figure range may be derived by using a known light taking out calculation software. An example of such light taking out calculation software is "Setfos™" (made by Fluxim AG.)

The specific thickness of each organic layer which enables to make the light distribution property of the organic EL element to be in the above-described figure range is varied in several ways depending on the materials constituting the each organic layer. An example thereof is described in the following.

In an organic EL element provided with a first light-emitting unit 12, an intermediate connector layer 13, and a second light-emitting unit 14 between an anode 11 and a cathode 15 as illustrated in FIG. 1, when the first light-emitting unit 12 is composed of: a first hole injection layer, a first hole transport layer, a first light-emitting layer, a first electron transport layer, and a first electron injection layer; and the second light-emitting unit 14 is composed of: a second hole injection layer, a second hole transport layer, a second light-emitting layer, a second electron transport layer, and a second electron injection layer, a suitable thickness of each layer is as follows. A total thickness of the first hole injection layer and the first hole transport layer is 85 to 105 nm; a total thickness of the first electron transport layer, the first electron injection layer, the intermediate connector layer 13, the second hole injection layer, and the second hole transport layer is 132 to 162 nm; and a total thickness of the second electron transport layer, the second electron injection layer is 23 to 30 nm.

Another method for adjusting the luminance L1 to L3 of the organic EL element 10 to be in the above-described range is a method of placing an optical film on the light-emitting side of the organic EL element 10.

Such an optical film is made of a transparent resin material, for example. Examples that may be used are: a micro-lens array or a dot pattern composed of a plurality of convex portions; a sheet type optical film or optical sheet having a diffraction grating or a concave-convex structure; and an optical film composed of a plurality of layers each having a different refractive index. In the present invention, the above-described light distribution property may be obtained by suitably adjusting the shape of the optical film.

Among known optical films, certain films have inferior transparency. Consequently, an organic EL element equipped with an optical film is likely to decrease its brightness compared with an organic EL element without being equipped with an optical film. Therefore, it is more preferable to adopt the above-described method of changing the layer thickness of each organic layer that constitutes the organic EL element.

It is preferable that the organic EL element of the present invention has a front chromaticity satisfying the following relationships in a CIE-xy chromaticity diagram when the front luminance L1 is 1,000 cd/$m^2$: $0.29 \leq y \leq 0.335$; and $y + x \geq 0.98$. By satisfying these requirements, red emission light may be obtained, and the organic EL element may be applied to a vehicle lamp fitting such as a tail lamp that emits red light.

Further, it is also preferable that the organic EL element of the present invention has a front chromaticity satisfying the following relationships in a CIE-xy chromaticity diagram when the front luminance L1 is 1,000 cd/$m^2$: $y \geq 0.39$; $y \geq 0.79 - 0.67x$; and $y \geq x - 0.120$. By satisfying these requirements, amber emission light maybe obtained, and the organic EL element may be applied to a vehicle lamp fitting such as a turn lamp that emits amber light.

The "x" and the "y" in the above-described range of chromaticity diagram each designate the chromaticity x and y in CIE 1931 Color Space.

The above-described chromaticity may be obtained by applying a predetermined electric current density to an organic EL element to give the front luminance L1 of 1,000 cd/$m^2$ and measured with Spectroradiometer CS-2000 (made by Konica Minolta Inc.).

[Detail of constitution of organic electroluminescent element]

In the following, there will be described details of the constitution of an organic EL element 10 illustrated in FIG. 1 having a constitution of: an anode 11, a first light-emitting unit 12, an intermediate connector 13, a second light-emitting unit 14, and a cathode 15, and a constitution of a flexible substrate 16 on which is prepared the organic EL element 10. Each constitution of the organic EL element 10 described in the following is only an example of an embodiment of the present invention, and it is possible to apply other constitution within the range that can constitute the above-described organic EL element.

[Anode]

As an anode 11 of an organic EL element 10, a metal having a large work function (4 eV or more, preferably, 4.3 eV or more), an alloy, and a conductive compound and a mixture thereof are utilized as an electrode substance. Specific examples of an electrode substance are: metals such as Au and Ag, and an alloy thereof; transparent conductive materials such as CuI, indium tin oxide (ITO), $SnO_2$, and ZnO. Further, a material such as IDIXO ($In_2O_3$-ZnO), which can form an amorphous and transparent electrode, may also be used.

The anode may be produced with a method of such as a vapor deposition method or a sputtering method using the above-described electrode materials. When emitted light is taken out from the anode 11 side (when the anode 11 is a first electrode layer), the transmittance is preferably set to be 10% or more. A sheet resistance of the anode is preferably a few hundred Ω/sq or less. Further, although a layer thickness of the anode depends on a material, it is generally selected in the range of 10 nm to 1 μm, and preferably in the range of 10 to 200 nm.

[Light-emitting unit]

The first light-emitting unit 12 is formed between the anode 11 and the intermediate connector 13. It is provided with at least one light-emitting layer incorporating a light-emitting organic material. The second light-emitting unit 14 is formed between the intermediate connector 13 and the cathode 15. It is provided with at least one light-emitting layer incorporating a light-emitting organic material. The first light-emitting unit 12 and the second light-emitting unit 14 may be provided with other layer between the light-emitting layer and the anode 11, the intermediate connector 13 or the cathode 15.
Hereafter, the first light-emitting unit 12 and the second light-emitting unit 14 are called together as a light-emitting unit and described.
Representative element constitutions of the light-emitting unit are as follows, however, the present invention is not limited to them.

(1) Hole injection transport layer / light-emitting layer / electron injection transport layer
(2) Hole injection transport layer / light-emitting layer / hole blocking layer / electron injection transport layer
(3) Hole injection transport layer / electron blocking layer / light-emitting layer / hole blocking layer / electron injection transport layer
(4) Hole injection layer / hole transport layer / light-emitting layer / electron transport layer / electron injection layer
(5) Hole injection layer / hole transport layer / light-emitting layer / hole blocking layer / electron transport layer / electron injection layer
(6) Hole injection layer / hole transport layer / electron blocking layer / light-emitting layer / hole blocking layer / electron transport layer / electron injection layer

In the above-described constitutions, the light-emitting layer is composed of one or a plurality of layers. When the light-emitting layer is composed of a plurality of layers, it may be formed a layer having the same composition as the intermediate connector layer 13 between the light-emitting layers.
An electron transport layer is a layer having a function of transporting an electron. An electron transport layer includes an electron injection layer, and a hole blocking layer in a broad sense. Further, an electron transport layer unit may be composed of a plurality of layers.
A hole transport layer is a layer having a function of transporting a hole. A hole transport layer includes a hole injection layer, and an electron blocking layer in a broad sense. Further, a hole transport layer unit may be composed of a plurality of layers.
Each layer that constitutes the light-emitting unit may be formed with a known material and a known forming method.
When a plurality of light-emitting units is formed in an organic EL element, it may be formed with the light-emitting units each having the same or a different composition. However, it is preferable that the light-emitting units each have the same layer and the same materials except for the light-emitting layer. In addition, the light-emitting units each have the same number of light-emitting layer. By this, it can reduce the number of used materials, and it has an advantage of a cost and a production aspect such control of quality. Further, when the formation method is a vapor deposition process, it has an advantage of production efficiency that a common film forming chamber may be easily used for producing each light-emitting unit.
The layer thickness of each layer incorporated in each light-emitting unit is made to the value derived by using a known light taking out calculation software, when the light distribution property is adjusted based on the distance between the emission point in the light-emitting layer and the anode or the cathode a as described above.
On the other hand, the layer thickness of each layer incorporated in each light-emitting unit is not limited in particular, when the light distribution property is adjusted by forming an optical film on the light-emitting side of the organic EL element 10. In this case, the layer thickness is preferably adjusted in the range of 5 to 200 nm, more preferably in the range of 10 to 100 nm from the viewpoint of uniformity of the formed film, and preventing the unnecessary high voltage during the light emission, and improving the stability of emission color relating to the driving current.
The light-emitting layer that is essential to the constituting layer of the light-emitting unit is described in the following,

[Light-emitting layer]

A light-emitting layer is a layer which provides a place of emitting light via an exciton produced by recombination of electrons and holes injected from an electrode or an adjacent layer. It is a layer including a light-emitting organic semiconductor film. It is preferable that the light-emitting layer incorporates a light-emitting dopant (a light-emitting dopant compound, a dopant compound, or simply called as a dopant) and a host compound (a matrix material, a light-emitting

host compound, or simply called as a host).

A method of forming a light-emitting layer is not limited in particular. It may be formed with conventionally known methods such as a vacuum vapor deposition method and a wet method. From the viewpoint of production cost of an organic EL element, it is preferable to form with a wet method.

(1. Light-emitting dopant)

As a light-emitting dopant, it is preferable to employ: a fluorescence emitting dopant (also referred to as a fluorescent dopant and a fluorescent compound) and a phosphorescence emitting dopant (also referred to as a phosphorescent dopant and a phosphorescent emitting compound).

A concentration of a light-emitting dopant in a light-emitting layer may be arbitrarily decided based on the specific dopant employed and the required conditions of the device. A concentration of a light-emitting dopant may be uniform, or it may have any concentration distribution in a thickness direction of the light-emitting layer.

It may be used a plurality of light-emitting dopants in the light-emitting layer. It may be used a combination of dopants each having a different structure, or a combination of a fluorescence emitting dopant and a phosphorescence emitting dopant. Any required emission color will be obtained by this.

It is preferable that the organic EL element of the present invention has red emission or amber emission. The red emission may be achieved by incorporating a red emitting dopant in a light-emitting layer. The amber emission may be achieved by solely incorporating a red emitting dopant having a color close to amber or a green emitting dopant, or by incorporating a combination of two or three kinds of red and green emitting dopants. When the amber emission is obtained by combination of red and green emitting dopants, usually employed are two kinds of dopants containing one red emitting dopant and one green emitting dopant.

The organic EL element may contain a plurality of emitting dopants each having a different emission color in the light-emitting layer to result in achieving white emission. The combination of the emitting dopants for achieving white emission is not limited in particular. It may be cited a combination of blue and orange, or a combination of blue, green, and red. It is preferable that "white" in the organic EL element of the present invention has chromaticity in the CIE 1931 Color Space at 1,000 cd/$m^2$ in the region of x = 0.39 $\pm$ 0.09 and y = 0.38 $\pm$ 0.08, when measurement is done to 2-degrees viewing angle front luminance via the aforesaid method.

(1-1. Phosphorescent Dopant)

A phosphorescent dopant is a compound that emits light upon the transition from an excited triplet state, and specifically emits phosphorescent light at room temperature (25 °C). It is a compound having a phosphorescence quantum yield of 0.01 or more at 25 °C. A preferable quantum yield of the phosphorescent dopant used in the light-emitting layer is 0.1 or more.

The above-described phosphorescence quantum yield may be determined by a method described in page 398 of "Bunkou II (Spectroscopy II)" of the series of "Jikken Kagaku Kouza 7 (Experimental Chemistry 7), 4th Edition" (1992, Maruzen Publishing Co., Ltd.). Any solvent may be used to determine the phosphorescence quantum yield in solution. A phosphorescent compound used in the light-emitting layer is only required to achieve the above-described phosphorescence quantum yield (0.01 or more) in any one of the solvents.

The phosphorescent dopant may be appropriately selected from any known compounds used in a light-emitting layer of an organic EL element.

Among them, preferable phosphorescence emitting dopants are organic metal complexes containing Ir as a center metal. More preferable are complexes containing at least one coordination mode selected from a metal-carbon bond, a metal-nitrogen bond, a metal-oxygen bond and a metal-sulfur bond.

(1-2. Fluorescence emitting dopant)

A fluorescence emitting dopant is a compound which is capable of emitting light from an excited singlet. It is not specifically limited as long as an emission from an excited singlet is observed.

As fluorescence emitting dopants, listed are compounds such as: an anthracene derivative, a pyrene derivative, a chrysene derivative, a fluoranthene derivative, a perylene derivative, a fluorene derivative, an arylacetylene derivative, a styrylarylene derivative, a styrylamine derivative, an arylamine derivative, a boron complex, a coumarin derivative, a pyran derivative, a cyanine derivative, a croconium derivative, a squarylium derivative, an oxobenzanthracene derivative, a fluorescein derivative, a rhodamine derivative, a pyrylium derivative, a perylene derivative, a polythiophene derivative, and a rare earth complex compound.

In addition, it may be used a light emitting dopant utilizing delayed fluorescence. Specific examples of utilizing delayed fluorescence are compounds described in: WO 2011/156793, JP-A 2011-213643, and JP-A 2010-93181.

(2. Host compound)

A host compound is a compound which mainly plays a role of injecting or transporting a charge in a light-emitting layer. In an organic EL element, an emission from the host compound itself is substantially not observed.
Preferably, a host compound is a compound exhibiting a phosphorescent quantum yield of the phosphorescence emission of less than 0. 1 at room temperature (25 °C) . More preferably, it is a compound exhibiting a phosphorescent quantum yield of less than 0.01. Further, among the compounds incorporated in the light-emitting layer, a mass ratio of the host compound in the aforesaid layer is preferably 20% or more.
It is preferable that an exited energy level of a host compound is higher than an exited energy level of a light-emitting dopant incorporated in the same layer.
Host compounds may be used singly or may be used in combination of two or more compounds. By using a plurality of host compounds, it is possible to adjust transfer of charge, thereby it is possible to achieve an organic EL element having high efficiency.
A host compound used in the light-emitting layer is not specifically limited, and known compounds used in known organic EL elements may be used. For example, it may be either a low molecular weight compound or a polymer compound having a repeating unit. Further, it may be a compound provided with a reactive group such as a vinyl group and an epoxy group.
A known light-emitting host which may be used is preferably a compound having a hole transporting ability and an electron transporting ability, as well as preventing elongation of an emission wavelength and having a high Tg (a glass transition temperature). It is preferable that a host compound has a Tg of 90 °C or more, more preferably, it has a Tg of 120 °C or more.
Here, a glass transition temperature (Tg) is a value obtained using DCS (Differential Scanning Colorimetry) based on the method in conformity to JIS-K-7121.

[Intermediate connector layer]

When the light-emitting units are laminated, it is preferable to place a non-light emitting intermediate connector layer between each light-emitting unit.
The intermediate connector layer 13 may be made to have a constitution of a single metal layer having a thickness of 0.1 to 10 nm. The intermediate connector layer 13 may be made to be a charge generating layer having a function of injecting an electron to the first light-emitting unit 12, and a function of injecting a hole to the second light-emitting unit 14.
When a single metal layer is used for the intermediate connector layer 13, there are concerns of generating of plasmon loss. Therefore, it is preferable that the intermediate connector layer 13 does not include a single metal layer and that it uses a constitution of a charge generating layer formed by laminating a layer having a function of injecting a hole with a layer having a function of injecting an electron.
It is possible to form an intermediate connector layer 13 by using the same material as used for preparation of the anode and the cathode. Further, it is possible to form an intermediate connector layer 13 by using a material having a lower conductivity than the anode and the cathode.
In the intermediate connector layer 13, the layer having a function of injection an electron may be formed with: an insulator or a semiconductor such as lithium oxide, lithium fluoride, and cesium carbonate. Otherwise, it may be used material prepared by adding an electron donating substance to a substance having a high electron transporting property.
The substance having a high electron transporting property is a substance mainly having an electron mobility of $10^{-6}$ $cm^2/Vs$. Any substance may be used as long as it has an electron transporting property lager than a hole transporting property.
The electron injection property may be increased by adding an electron donating substance to a substance having a high electron transporting property. As a result, a driving voltage of a light-emitting element may be reduced. Examples of a usable electron donating substance are: an alkali metal, an alkali earth metal, a rare earth metal, a metal of 13 Group in the periodic table, an oxide thereof, and a carbonate thereof.
In the intermediate connector layer 13, the layer having a function of injection a hole may be formed with: an insulator or a semiconductor such as molybdenum oxide, vanadium oxide, rhenium oxide and ruthenium oxide. Otherwise, it may be used a material prepared by adding an electron accepting substance to a substance having a high hole transporting property. Further, it may be used a layer made of an electron accepting substance.
The substance having a high hole transporting property is a substance mainly having a hole mobility of $10^{-6}$ $cm^2/Vs$. Any substance may be used as long as it has a hole transporting property larger than an electron.
The hole injection property may be increased by adding an electron accepting substance to a substance having a high hole transporting property. As a result, a driving voltage of a light-emitting element may be reduced. As an electron accepting substance, it may be used 7,7,8,8-tetracyano-2,3,5,6-tetrafluoroquinodimethene (F4-TCNQ), Chloranil, and

oxide of a transition metal.

By using one or both constitutions of: a constitution of adding an electron accepting substance to a substance having a high hole transporting property; and a constitution of adding an electron donating substance to a substance having a high electron transporting property, it may be reduced increase of driving voltage when the thickness of the intermediate connector layer 13 is made large. When the thickness of the intermediate connector layer 13 is made large, a short circuit caused by a small foreign matter or a mechanical impact may be avoided. Thus, it may be obtained a light-emitting element of high reliance without increasing the driving voltage.

In the intermediate connector layer 13, other layer may be formed between the layer having a function of injecting a hole and the layer having a function of injecting an electron according to necessity. For example, it may be formed a conductive layer such as ITO layer, or an electron relay layer. An electron relay layer has a function of decreasing the voltage loss induced between the layer having a function of injecting a hole and the layer having a function of injecting an electron according to necessity. Specifically, it is preferable to use a material having a LUMO level of -5.0 eV or more, more preferably, a material having a LUMO level of -5.0 to -3.0 eV.

[Cathode]

As a cathode 15, a metal a having a small work function (4 eV or less) (it is called as an electron injective metal), an alloy, a conductive compound and a mixture thereof are utilized as an electrode substance. Specific examples of the aforesaid electrode substance includes: sodium, sodium-potassium alloy, magnesium, lithium, a magnesium/copper mixture, a magnesium/silver mixture, a magnesium/aluminum mixture, a magnesium/indium mixture, an aluminum/aluminum oxide ($Al_2O_3$) mixture, indium, a lithium/aluminum mixture, aluminum, silver an alloy mainly composed of silver, and a rare earth metal.

The cathode 15 may be made by using these electrode substances with a method such as a vapor deposition method or a sputtering method.

When emitted light is taken out from the cathode 15 side (when the cathode 15 is a first electrode layer), the transmittance is preferably set to be 10% or more. A sheet resistance of the cathode 15 is preferably a few hundred Ω/sq or less. Further, although a layer thickness of the cathode 15 depends on a material, it is generally selected in the range of 10 nm to 5 μm, and preferably in the range of 50 to 200 nm.

[Flexible substrate]

The material of the flexible substrate 16 used for the organic EL element 10 is not limited in particular as long as it is a material of plastic or glass having flexibility. Preferably usable materials are transparent resin films.

Examples of a resin film include: polyesters such as polyethylene terephthalate (PET) and polyethylene naphthalate (PEN); polyethylene, polypropylene, cellophane; cellulose esters and their derivatives such as cellulose diacetate, cellulose triacetate (TAC), cellulose acetate butyrate, cellulose acetate propionate (CAP), cellulose acetate phthalate, and cellulose nitrate; polyvinylidene chloride, polyvinyl alcohol, polyethylene vinyl alcohol, syndiotactic polystyrene, polycarbonate, norbornene resin, polymethyl pentene, polyether ketone, polyimide, polyether sulfone (PES), polyphenylene sulfide, polysulfones, polyether imide, polyether ketone imide, polyamide, fluororesin, Nylon, polymethyl methacrylate, acrylic resin, polyallylates; and cycloolefin resins such as ARTON (trade name, made by JSR Co. Ltd.) and APEL (trade name, made by Mitsui Chemicals, Inc.).

On the surface of a resin film, it may be formed a film incorporating an inorganic or an organic compound, or it may be formed a hybrid film incorporating both compounds. A preferable film is a barrier film having a water vapor permeability of 0.01 $g/m^2 \cdot 24h$ or less (at 25 ± 0.5 °C, and 90 ± 2 %RH) determined based on JIS K 7129-1992. A further preferable film is a high barrier film having an oxygen permeability of 1 x $10^{-3}$ $ml/m^2 \cdot 24h \cdot atm$ or less determined based on JIS K 7126-1987, and a water vapor permeabilityl of 1 x $10^{-5}$ $g/m^2 \cdot 24h$ or less.

As materials that form a barrier film, employed may be those which retard penetration of moisture and oxygen, which deteriorate the element. For example, it is possible to employ silicon oxide, silicon dioxide, and silicon nitride. Further, in order to improve the brittleness of the aforesaid film, it is more preferable to achieve a laminated layer structure of inorganic layers and organic layers. The laminating order of the inorganic layer and the organic layer is not particularly limited, but it is preferable that both are alternatively laminated a plurality of times. Barrier film forming methods are not particularly limited, it may be used conventionally known methods.

[Other constituting members]

As a sealing way for sealing an organic EL element 10, it can adopt a known material and a known method within the scope that will not deteriorate the flexibility of the organic EL element 10. In addition, in order to increase a mechanical strength of the organic EL element 10, it may form a known protective film or protective plate on the outside

of the sealing member within the scope that will not deteriorate the flexibility of the organic EL element 10.

In the above-described embodiments of the present invention, a bottom emission type organic EL element was described. It had a constitution from the flexible substrate side laminated with: an anode to become a transparent electrode, a first light-emitting unit, an intermediate connector layer, a second light-emitting unit, and a cathode to become a reflective electrode. However, the present invention is not limited to this. For example, the lamination order of each layer may be the inverse. The location of the anode and the cathode may be exchanged. This means that it is possible that the first electrode layer is an anode, and the second electrode layer is a cathode. In this case, the cathode becomes a transparent electrode, and the anode becomes a reflective electrode.

The present invention has no specific limitation with respect to the composition and the laminated number of the light-emitting units, and the laminated number of the light-emitting layers. It may form a constitution that enables to realize a required organic EL element. For example, the organic EL element by be provided with only one light-emitting unit, or it may be provided with three or more light-emitting units.

[Vehicle lamp fitting]

The vehicle lamp fitting of the present invention has a constitution provided with the above-described organic EL element. The vehicle lamp fitting of the present invention may be suitably applied to any of a head lamp, a tail lamp, a stop lamp, a back lamp, and a turn lamp.

An application example of a vehicle lamp fitting of the present invention is described in the following by referring to FIG. 2. As illustrated in FIG. 2, a head lamp 21 is placed in the forward portion of a vehicle 20, and a vehicle lamp fitting 22 of the present invention is placed in the rear corner of the vehicle 20. The vehicle lamp fitting 22 has a constitution that will distribute the emission light to the rear direction of the vehicle 20. In FIG. 2, the forward direction, the rear direction, the left direction, and the right direction are described when they are viewed from the driver of the vehicle 20.

The vehicle lamp fitting 22 is composed of: a housing 23 placed in the concave portion formed in in the rear corner of the vehicle 20; a transparent cover 24 formed to be fit to the body shape of the vehicle 20 and to cover the housing 23; and the organic EL element 10 used for a light source placed in a lighting room 25 formed between the housing 23 and the transparent cover 24.

The organic EL element 10 is formed in a belt shape that extends to the right and left direction of the vehicle 20. It is held in the housing 23 in a partially bent condition so that it is fit to the body shape of the vehicle 20.

By suitable selecting the material for the light-emitting layer of the organic EL element 10, it is made to have a composition to generate: white light for a back lamp; red light for a tail or stop lamp; or yellow light for a turn lamp. It may be used an organic EL element 10 that emits white light, and the above-described colors may be generated by placing a color filter on the organic EL element.

## EXAMPLES

Hereafter, the present invention will be described specifically by referring to Examples, however, the present invention is not limited to them. In Examples, the term "parts" or "%" is used. Unless particularly mentioned, it represents "mass parts" or "mass%".

«Preparation of Organic EL element 101»

It was prepared an organic EL element 101 having a constitution described in FIG. 1 in accordance with the following method.

(Preparation of Flexible substrate provided with gas barrier layer)

A polyethylene naphthalate film (abbreviation PEN, made by Teijin Dupont Co. Ltd.) was used as a flexible substrate. On the whole surface of the flexible substrate (PEN) that forms a first electrode layer (a transparent electrode, a cathode) was formed an inorganic gas barrier layer made of $SiO_x$ with an atmospheric plasma discharge treating apparatus having a composition described in JP-ANo. 2004-68143 to have a thickness of 500 nm. Thus, it was prepared a flexible substrate provided with a gas barrier layer.

(Formation of High refractive layer and Underlayer)

The flexible substrate formed with a gas barrier layer was fixed in a substrate holder of a commercially available electron beam vapor deposition apparatus. Niobium oxide ($Nb_2O_5$) was placed in a heating boat. The substrate holder and the heating boat were placed in a vacuum chamber of the electron beam vapor deposition apparatus.

Subsequently, after reducing the pressure of a vacuum chamber of the electron beam vapor deposition apparatus to 4 x $10^{-4}$ Pa, an electron beam was irradiated to the heating boat containing Niobium oxide ($Nb_2O_5$) to form a high refractive layer made of $Nb_2O_5$ with a thickness of 30 nm at a deposition rate of 0.1 to 0.2 nm/second on the flexible substrate. Then, the flexible substrate was transferred from the plasma treatment chamber to the vacuum chamber of the vacuum deposition apparatus without exposing the flexible substrate to the atmosphere.

Subsequently, after reducing the pressure of the vacuum chamber to 4 x $10^{-4}$ Pa, the heating boat loaded with the following nitrogen containing compound 1 was heated via application of electric current. It was produced an underlayer having a thickness of 15 nm at a deposition rate of 0. 1 to 0.2 nm/second.

**Compound 1**

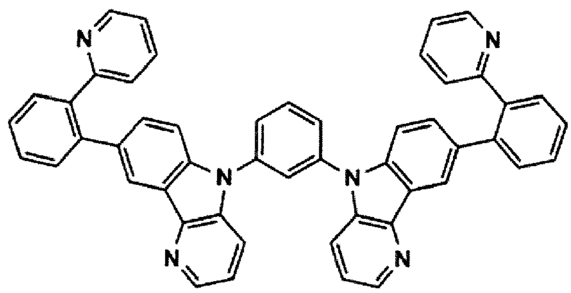

(Formation of Anode)

The flexible substrate provided with a gas barrier layer was fixed in the vacuum chamber. After reducing the pressure of the vacuum chamber to 4 x $10^{-4}$ Pa, the heating boat containing silver was heated via application of electric current, whereby it was formed an anode made of silver having a thickness of 13 nm at a deposition rate of 0.1 to 0.2 nm/second.

(Formation of First light-emitting unit)

On the prepared anode of the flexible substrate was formed a first light-emitting unit in accordance with the processes described below. The flexible substrate was dried in a glove box having a dew point of -80 °C or less, and an oxygen content of 1 ppm or less. Then, the flexible substrate was transferred from the glove box in the vacuum vapor deposition apparatus to form a first light-emitting unit without exposing the flexible substrate to the atmosphere.

Each heating boat in the vacuum vapor deposition apparatus was charged with an optimum amount of constituting material for each layer. The used heating boat was made of a low resistive heating material of molybdenum or tungsten.

Subsequently, after reducing the pressure of the vacuum chamber of the vacuum vapor deposition apparatus to 1 x $10^{-4}$ Pa, a compound M-1 (MTDATA) represented by the following chemical formula was deposited on the anode at a deposition rate of 0.1 nm/second to form a hole injection layer having a thickness of 15 nm.

**M−1**

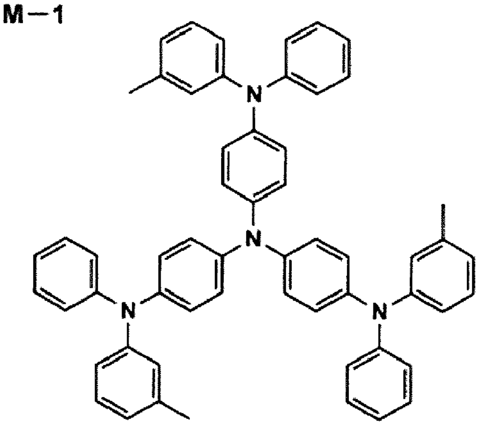

Subsequently, a compound M-2 (α-NPD) represented by the following chemical formula was deposited on the hole injection layer to form a hole transport layer having a thickness of 80 nm.

M−2

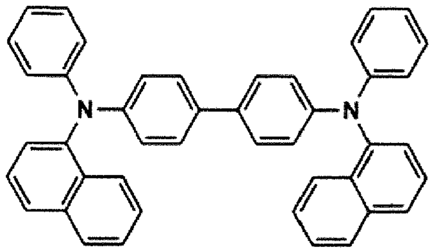

Subsequently, a compound GD-1, a compound RD-1, a compound H-2 as represented by the following chemical structures were co-deposited at a deposition rate of 0.1 nm/second in a manner that the volume ratio of the compound GD-1 became 10% and the compound RD-1 became 10%, and it was formed a red phosphorescent layer having a thickness of 30 nm.

GD−1

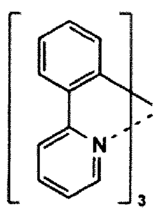

RD−1

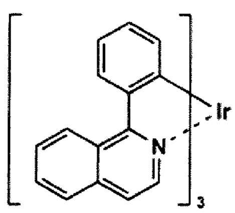

H−2

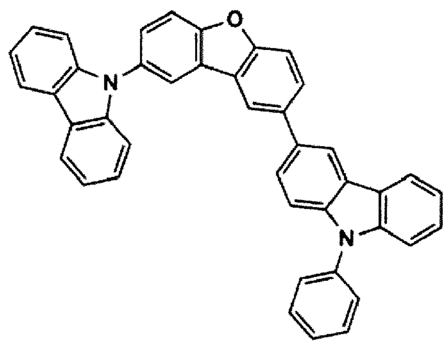

Subsequently, the compound 1 was deposited at a deposition rate of 0. 1 nm/second, and it was formed an electron transport layer having a thickness of 20 nm.

Further, LiF was deposited at a deposition rate of 0.1 nm/second, and it was formed an electron injection layer having a thickness of 1.2 nm.

(Formation of Intermediate connector layer)

Subsequently, aluminum was deposited on the electron injection layer to form an intermediate connector layer solely made of metal having a thickness of 1 nm.

(Formation of Second light-emitting unit)

Subsequently, the compound M-1 was deposited on the intermediate connector layer at a deposition rate of 0.1 nm/second to form a hole injection layer having a thickness of 15 nm.

Subsequently, the compound M-2 was deposited on the hole injection layer to form a hole transport layer having a thickness of 110 nm.

Subsequently, the compound GD-1, the compound RD-1, and the compound H-2 were co-deposited at a deposition rate of 0. 1 nm/second in a manner that the volume ratio of the compound GD-1 became 10% and the compound RD-1 became 10%, and it was formed a red phosphorescent layer having a thickness of 20 nm.

Afterward, the compound 1 was deposited at a deposition rate of 0.1 nm/second, and it was formed an electron transport layer having a thickness of 25 nm.

Further, LiF was deposited at a deposition rate of 0.1 nm/second, and it was formed an electron injection layer having a thickness of 1.5 nm.

(Formation of Cathode)

Subsequently, aluminum was deposited to have a thickness of 100 nm to form a cathode (reflective electrode, opaque electrode).

(Preparation of Sealing structure)

A sealing film was stuck to cover the portion from the anode to the cathode, and sealing was done as described below.

An adhesive was coated on a non-alkali glass substrate having a thickness of 0.7 mm, and it was dried at 120 °C for 2 minutes to form an adhesive layer having a thickness of 20 μm. To the adhesive layer was stuck a polyethylene terephthalate film having a thickness of 50 μm provided with an aluminum foil having a thickness of 100 μm. Thus, it was prepared a sealing film. After leaving this sealing film in a nitrogen atmosphere for 24 hours or more, the detachment sheet was removed. Then, the sealing film was stuck to cover the cathode with a vacuum laminator heated at 80 °C. Further, the stuck matter was heated at 120 °C for 30 minutes to complete the sealing. Thus, it was prepared an organic EL element 101 having a light-emitting region of 200 mm x 40 mm.

«Preparation of Organic EL element 102»

An organic EL element 102 was prepared in the same manner as preparation of the organic EL element 101 except that the thickness of the electron transport layer in the second light-emitting unit was changed to 30 nm.

«Preparation of Organic EL element 103»

An organic EL element 103 was prepared in the same manner as preparation of the organic EL element 101 except that the thickness of the electron transport layer in the second light-emitting unit was changed to 40 nm.

«Preparation of Organic EL element 104»

An organic EL element 104 was prepared in the same manner as preparation of the organic EL element 101 except the following changes were made: the thickness of the hole transport layer in the first light-emitting unit was changed to 50 nm; the thickness of the electron transport layer in the first light-emitting unit was changed to 35 nm; and the intermediate connector layer and the second light-emitting unit were not formed.

Subsequently, on the surface of the prepared flexible substrate for the organic EL element that was not provided with the first light-emitting unit was placed a prism sheet described in JP-A No. 2007-188065. Thus, it was prepared an organic EL element 104 having a known Lambertian distribution property.

«Preparation of Organic EL element 105»

An organic EL element 105 was prepared in the same manner as preparation of the organic EL element 101 except that the thickness of the electron transport layer in the second light-emitting unit was changed to 10 nm.

«Preparation of Organic EL element 106»

After preparation of the organic EL element 105, on the surface of the prepared flexible substrate that was not provided with the first light-emitting unit was placed a prism sheet having a convex shape described in JP-A No. 2007-188065 to obtain the same light distribution form as the organic EL element 1. Thus, an organic EL element 106 was prepared.

«Preparation of Organic EL element 107»

An organic EL element 107 was prepared in the same manner as preparation of the organic EL element 101 except that the thickness of the electron transport layer in the second light-emitting unit was changed to 50 nm.

<<Evaluation of Organic EL elements 101 to 107>>

The prepared organic EL elements 101 to 107 were subjected to the following evaluation tests. The obtained evaluation results are listed in Table 1.

(1) Measurement of Light distribution property

The prepared organic EL elements 101 to 107 each were set to a rotating stage that automatically rotates the organic EL elements 101 to 107. The light intensity and the spectrum were measured with Spectroradiometer CS-2000 (made by Konica Minolta Inc.). In the measurement, a constant electric current (5 mA/$cm^2$) was passed to the organic EL element. While making the organic EL element to light, multiple measurements were carried out in the range of ± 80 degrees, provided that an orthogonal direction to the light-emitting region of the organic EL element was set to be 0 degrees.

From the obtained light distribution property of the organic EL element, the values of L2/L1 and L3/L1 of each organic EL element were determined.

(2) Evaluation of Brightness uniformity

The prepared organic EL elements 101 to 107 each were fixed in a bent condition so that the light-emitting region had a curvature of 50 mm. A constant electric current (5 mA/$cm^2$) was passed to the organic EL element to emit light. The center portion of the organic EL element was visually observed in the front direction at the observation position in a distance of 1 m from the organic EL element. The brightness uniformity of the organic EL element was evaluated by 10 general monitors according to the following criteria. When the evaluation results were either "○" or "Δ", it was decided that the organic EL element had sufficient brightness uniformity for practically use.

○: 9 or more general monitors judged that the light-emitting region was uniform;
Δ: 5 to 8 general monitors judged that the light-emitting region was uniform; and
×: 4 or less general monitors judged that the light-emitting region was uniform.

(3) Evaluation of Brightness

The prepared organic EL elements 101 to 107 each were fixed in a bent condition so that the light-emitting region had a curvature of 50 mm. A constant electric current (5 mA/$cm^2$) was passed to the organic EL element to emit light. The center portion of the organic EL element was visually observed in the front direction at the observation position in a distance of 1 m from the organic EL element. The brightness of the organic EL element was evaluated by 10 general monitors according to the following criteria. When the evaluation results were either "○" or "Δ", it was decided that the organic EL element had sufficient brightness for practical use. In this evaluation test, the evaluation was done by comparing the brightness of the sample compared with the brightness of the emitted light by the organic EL element 104.

○: 9 or more general monitors judged that the brightness of the sample was the same as the organic EL element 104;

Δ: 5 to 8 general monitors judged that the brightness of the sample was the same as the organic EL element 104; and

× : 4 or less general monitors judged that the brightness of the sample was the same as the organic EL element 104.

Table 1

| Organic EL element No. | Light distribution property | | Evaluation | | Remarks |
|---|---|---|---|---|---|
| | L2/L1 | L3/L1 | Brightness uniformity | Brightness | |
| 101 | 0.95 | 0. 15 | ○ | ○ | Present invention |
| 102 | 1.02 | 0.30 | ○ | ○ | Present invention |
| 103 | 1.12 | 0.40 | × | ○ | Present invention |
| 104 | 0. 95 | 0.50 | × | Standard | Comparative example |
| 105 | 0.80 | 0.11 | × | ○ | Comparative example |
| 106 | 0. 95 | 0. 15 | ○ | Δ | Present invention |
| 107 | 1.25 | 0.45 | × | ○ | Comparative example |

As demonstrated in Table 1, the organic EL elements 101 to 103, and 106 satisfying the relationships of: $0.85 \leq L2/L1 \leq 1.20$; and $L3/L1 \leq 0.45$ are excellent in the brightness uniformity of the light-emission region compared with the organic EL elements 104, 105, and 107 not satisfying the above-described relationships. Based on these results, it can be said that an organic electroluminescent element satisfying the above-described relationships can achieve high visibility and uniform brightness of the emission light when it is viewed from the rear vehicle.

Although the organic EL element 106 that was equipped with a prism sheet exhibited the uniform brightness in the light-emitting region, it was found that the brightness thereof was decreased. Consequently, as an adjusting method of the luminance L1 to L3 in the above-described range, it is more preferable to adopt the method of changing a thickness of each layer constituting an organic EL element than the method of providing an optical film to the organic EL element.

## DESCRIPTION OF SYMBOLS

10: Organic EL element
11: Anode (First electrode layer)
12: First light-emitting unit (Organic layer unit)
14: Second light-emitting unit (Organic layer unit)
15: Cathode (Second electrode layer)
16: Flexible substrate
22: Vehicle lamp fitting

## Claims

1. An organic electroluminescent element comprising a flexible substrate having thereon a first electrode layer, an organic layer unit containing a light-emitting layer formed on the first electrode layer, and a second electrode layer formed on the organic layer unit, wherein the organic electroluminescent element emits light to an outside of the organic electroluminescent element with a light distribution property of the emitted light satisfying the following relationships of:

$$0.85 \leq L2/L1 \leq 1.20;$$

and

$$L3/L1 \leq 0.45,$$

provided that L1 is a front luminance, L2 is a luminance of view angle 20 degrees, and L3 is a luminance of view angle 60 degrees.

2. The organic electroluminescent element described in claim 1,
wherein the front luminance L1, the luminance of view angle 20 degrees L2, and the luminance of view angle 60 degrees L3 satisfy the following relationships of:

$$0.90 \leq L2/L1 \leq 1.10;$$

and

$$L3/L1 \leq 0.45.$$

3. The organic electroluminescent element described in claim 1,

having a front chromaticity satisfying the following relationships in a CIE-xy chromaticity diagram when the front luminance L1 is 1,000 cd/m$^2$:

$$0.29 \leq y \leq 0.335;$$

and

$$y + x \geq 0.98.$$

**4.** The organic electroluminescent element described in claim 1,
having a front chromaticity satisfying the following relationships in a CIE-xy chromaticity diagram when the front luminance L1 is 1,000 cd/m$^2$:

$$y \geq 0.39;$$

$$y \geq 0.79 - 0.67x;$$

and

$$y \geq x - 0.120.$$

**5.** The organic electroluminescent element described in claim 1,
wherein two or more organic layer units are laminated between the first electrode layer and the second electrode layer.

**6.** A vehicle lamp fitting provided with the organic electroluminescent element described in claim 1.

FIG.1

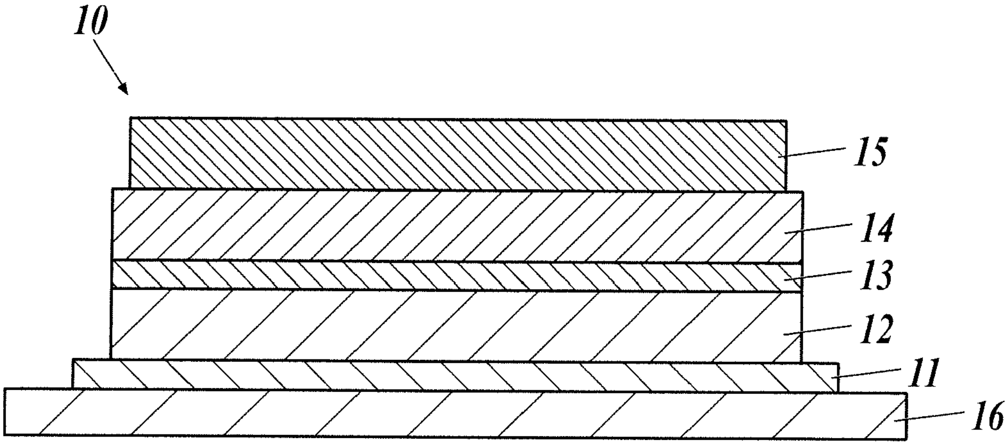
10
15
14
13
12
11
16

FIG.2

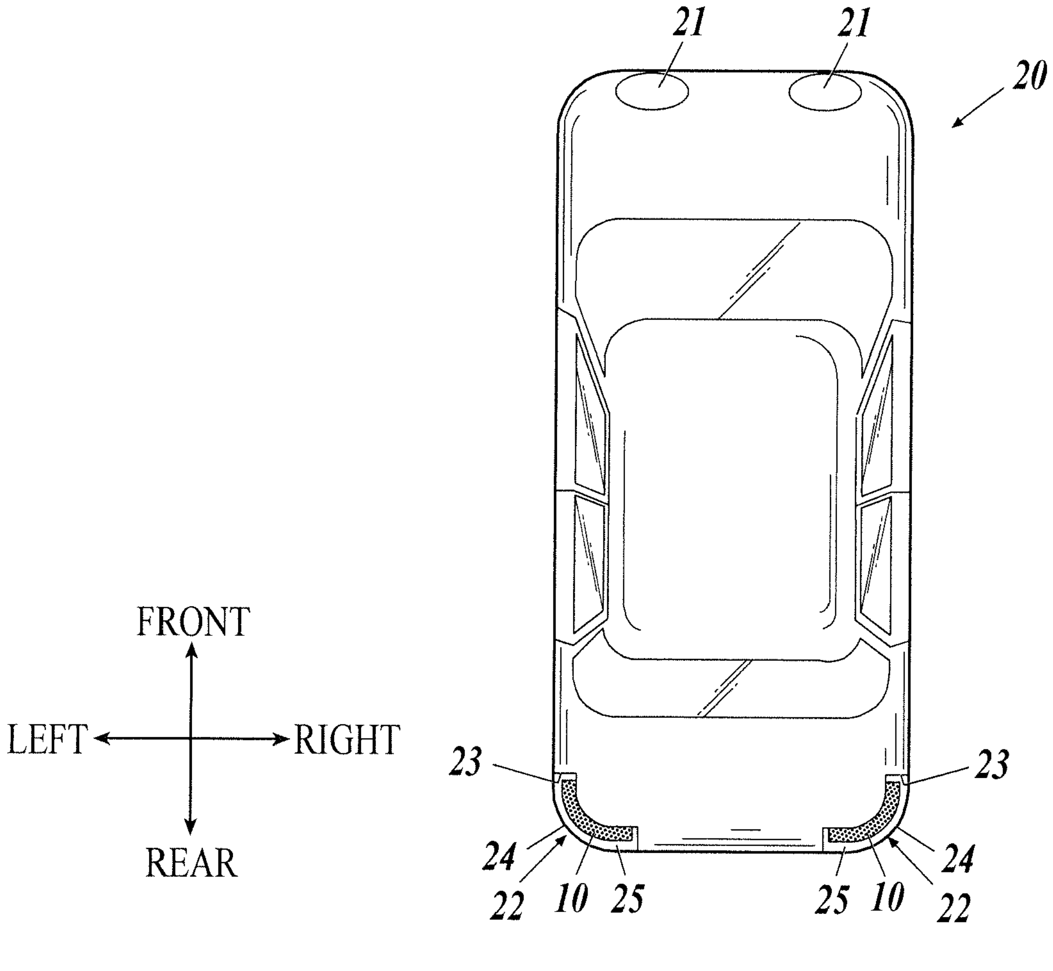
21
21
20
FRONT
LEFT
RIGHT
REAR
23
23
24
22
10
25
25
10
24
22

Europäisches Patentamt
European Patent Office
Office européen des brevets

# EUROPEAN SEARCH REPORT

Application Number
EP 16 18 0897

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2015/023046 A1 (SHIDO MASAYA [JP] ET AL) 22 January 2015 (2015-01-22)<br>* paragraph [0020] - paragraph [0036]; figures 1-7 *<br>----- | 1-6 | INV.<br>H01L51/52<br>F21S8/10 |
| X | EP 2 815 920 A1 (KOITO MFG CO LTD [JP]) 24 December 2014 (2014-12-24)<br>* paragraph [0007] - paragraph [0056]; figures 1-5 *<br>----- | 1-6 | |
| X | DE 10 2007 054037 A1 (OSRAM OPTO SEMICONDUCTORS GMBH [DE]) 2 April 2009 (2009-04-02)<br>* paragraph [0051] - paragraph [0083]; figures 1-3,5 *<br>----- | 1-6 | |
| A | EP 2 340 965 A1 (KOITO MFG CO LTD [JP]) 6 July 2011 (2011-07-06)<br>* the whole document *<br>----- | 1-4 | |

TECHNICAL FIELDS SEARCHED (IPC)

H01L
F21S

The present search report has been drawn up for all claims

1

| Place of search | Date of completion of the search | Examiner |
|---|---|---|
| The Hague | 10 January 2017 | Konrádsson, Ásgeir |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

# ANNEX TO THE EUROPEAN SEARCH REPORT ON EUROPEAN PATENT APPLICATION NO.

EP 16 18 0897

This annex lists the patent family members relating to the patent documents cited in the above-mentioned European search report. The members are as contained in the European Patent Office EDP file on
The European Patent Office is in no way liable for these particulars which are merely given for the purpose of information.

10-01-2017

| Patent document cited in search report | Publication date | Patent family member(s) | Publication date |
|---|---|---|---|
| US 2015023046 A1 | 22-01-2015 | CN 104302032 A | 21-01-2015 |
| | | JP 2015022917 A | 02-02-2015 |
| | | US 2015023046 A1 | 22-01-2015 |
| EP 2815920 A1 | 24-12-2014 | CN 104235723 A | 24-12-2014 |
| | | EP 2815920 A1 | 24-12-2014 |
| | | JP 2015005552 A | 08-01-2015 |
| | | US 2014376252 A1 | 25-12-2014 |
| DE 102007054037 A1 | 02-04-2009 | DE 102007054037 A1 | 02-04-2009 |
| | | JP 5394685 B2 | 22-01-2014 |
| | | JP 2009087938 A | 23-04-2009 |
| | | US 2009097234 A1 | 16-04-2009 |
| EP 2340965 A1 | 06-07-2011 | EP 2340965 A1 | 06-07-2011 |
| | | JP 5520023 B2 | 11-06-2014 |
| | | JP 2011124003 A | 23-06-2011 |
| | | US 2011134654 A1 | 09-06-2011 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2015176240 A
- JP 2015005552 A
- WO 2011156793 A
- JP 2011213643 A
- JP 2010093181 A
- JP 2004068143 A
- JP 2007188065 A


### Non-patent literature cited in the description


- Jikken Kagaku Kouza 7 (Experimental Chemistry 7). Maruzen Publishing Co., Ltd, 1992